# EUROPÄISCHE PATENTSCHRIFT

(11) **EP 0 487 806 B1**
(45) Veröffentlichungstag und Bekanntmachung des Hinweises auf die Patenterteilung: **10.01.1996**
(21) Anmeldenummer: 90810914.3
(22) Anmeldetag: 26.11.1990
(51) Int. Cl.: G01F 23/24, G01F 23/22, F17C 13/02, G05D 9/12

(54) **Anordnung zur Niveaumessung verflüssigter Gase**
Level measuring device for liquified gases
Dispositif pour la mesure du niveau de gaz liquéfiés

(43) Veröffentlichungstag der Anmeldung: 03.06.1992
(73) Patentinhaber: BALZERS AKTIENGESELLSCHAFT, FL-9496 Balzers (LI)
(72) Erfinder: Gleichmann, Lüder, O-6235 Ilmenau (DE); Löbel, Gerd, O-1144 Berlin (DE)

(56) Entgegenhaltungen:
- DD-A- 203 143
- DE-A- 1 809 820
- US-A- 3 603 833
- US-A- 4 404 809

## Beschreibung

Die Erfindung ist überall dort anwendbar, wo das Vorhandensein oder eine bestimmte Füllhöhe von verflüssigten Gasen, insbesondere von Flüssigstickstoff, Flüssigsauerstoff, Flüssighelium, usw. gemessen werden muss.

Nach DE-OS 39 25 927, EP 0 360 405, DD-PS 203 143 sowie nach US-PS 4,404,809 sind Anordnungen zur Messung beziehungsweise Regelung von Niveaus verflüssigter Gase bekannt. Zur Pegeldetektion ist bekannt Sensoren wie speziell hergestellte Kohleschichtwiderstände, Lichtschranken, Widerstandsthermometer, Halbleiterdioden, Schwimmer sowie Druckdosen mit Heizung und Kontakt einzusetzen. Eine Niveauregelung besteht beispielsweise aus einem Dreiwegventil, einer Steuerung (Regelung) sowie einem Flüssiggasvorratsbehälter und einem zweiten Flüssiggasbehälter wobei in dem zweiten Flüssiggasbehälter der Füllstand konstant gehalten wurde. Ueber eine Steuereinrichtung wird ein Dreiwegventil betätigt, beim Nachfüllvorgang die Abdampföffnung des Vorratsbehälters verschlossen und mittels Heizer im Vorratsbehälter ein Druck erzeugt, der das Flüssiggas zum zweiten Behälter fördert. Andere Anordnungen verzichten auf den Heizer und benutzen ein von aussen zugeführtes Druckgas, mitunter auch Druckluft.

Diesen Lösungen haften folgende Nachteile an: Die in US-PS 4,404,809 gezeigte Anordnung benötigt zweimal 4 genau ausgemessene Widerstände zur Bildung von Brückenschaltungen. Bei der in DD-PS 203 143 benutzten Anordnung kann ein Vereisen der Bauelemente erfolgen, wodurch sie für optische Strahlung (auch Infrarot) undurchlässig werden. Mechanische Schwimmer frieren bei den auftretenden Temperaturen oft fest, bei Kontakten entstehen häufig Korrosionserscheinungen, da auf tiefe Temperaturen gekühlte Teile zum Beschlagen neigen (Wasserdampf der Luft wird ausgefroren und taut danach ab). Ein Nachteil bei der Verwendung von temperaturabhängigen Widerständen als Sensor sind die geringen Signaländerungen. Auch die Verwendung einer üblichen Halbleiterdiode zeigt nur geringe temperaturabhängige Aenderungen der Flussspannung. Diese liegt im Bereich von 2 mV pro Grad Kelvin Temperaturänderung. Die Auswertung solcher Sensorsignale ist entsprechend aufwendig und begrenzt die Messpräzision und Zuverlässigkeit stark.

Aus DE-A-1 809 820 ist eine Anordnung zur Füllstandsmessung von kryogenen Flüssigkeiten bekannt, die eine Sprunghafte Änderung der Schwellenspannung von Dioden bei tiefen Temperaturen zur Füllstandsmessung ausnutzt.

Ziel der Erfindung ist es, eine Anordnung zu schaffen, die die erwähnten Nachteile vermeidet. Der Erfindung liegt die Aufgabe zugrunde einen speziellen Sensor mit hohem Signalausgang und hoher Zuverlässigkeit zur Pegelstandsmessung von verflüssigten Gasen zu realisieren, mit welchem einfache Niveauregelanordnungen hoher Zuverlässigkeit ermöglicht werden. Die Kennlinie des Sensors soll eine solch grosse Steilheit und Empfindlichkeit besitzen, dass nur beim direkten Eintauchen bzw. einem anderen direkten Wärmekontakt desselben in das verflüssigte Gas ein steiler Anstieg der elektrischen Spannung entsteht (U_{F} 8 bis 12 V). Dieser Anstieg lässt sich ohne komplizierte Auswerteelektronik mit einfachen Schwellwertschaltern zuverlässig auswerten.

Die Lösung dieser Aufgabe geschieht erfindungsgemäss dadurch, dass als Pegelsensoren LED's (Leuchtdioden) bzw. andere pn-Strukturen auf Ga P oder GaAs-P-Basis verwendet werden. Wenn der pn-Uebergang dort mit N₂-dotiert ist, besonders geeignet sind grün- und gelbleuchtende LED's, kommt bei diesem überraschenderweise unterhalb -50 °C eine starke temperaturabhängige Nichtlinearität der Flussspannung (U_{F}) zustande. Die Flussspannung beträgt üblicherweise etwa 2 V. Bei -196 °C stellen sich Flussspannungen von ca. 8 bis 12 V ein. Dabei ist besonders charakteristisch, dass diese hohe Flussspannung nur im eingetauchten Zustand auftritt. Dies ist auf Veränderungen im pn-Uebergang zurückzuführen. Schon 1 bis 2 mm über dem Flüssiggaspegel ist diese hohe Flussspannung auf 3 bis 4 V gesunken. Die Speisung der LED erfolgt dabei aus einer Konstantstromquelle. Weiterhin ist charakteristisch, dass dabei eine Verfärbung des emittierten Lichtes eintritt. So verändert eine grün stahlende LED ihr Licht in gelbliches, eine gelbe in grünliches Licht. Auch dieser Effekt bildet sich sofort zurück, wenn der Sensor 1 bis 2 mm über dem Flüssiggaspegel steht. Diese spektrale Lichtveränderung lässt sich ebenfalls zur Flüssiggaspegeldetektion benutzen. Dazu werden entsprechende lichtdurchlässige Filterschichten entweder auf die LED, einem Photoempfänger oder zwischen beiden angeordnet. Bei der Anwendung in einem Niveauregelsystem gewährleisten entsprechende Zeitglieder in der Steuereinrichtung, dass der Flüssiggaspegel auch tatsächlich auf der vorgegebenen Höhe steht. Kurzzeitige Störimpulse können mit einem Tiefpass unterdrückt werden.

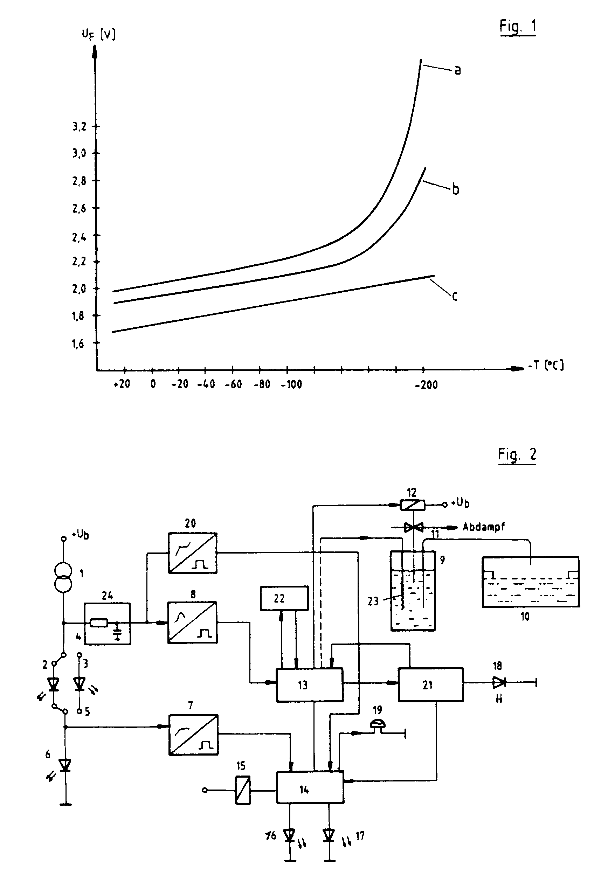

Die Erfindung soll anhand der Figuren 1 und 2 näher erläutert werden. Die Figur 1 zeigt die Flussspannungswerte U_{F} von verschiedenen Dioden in Abhängigkeit der Temperatur T an den Dioden. Die Kurven a) und b) zeigen ein stark nichtlineares Verhalten. Schon bei ca. 50 -°C beginnen sich die Flussspannungswerte U_{F} überproportional zu erhöhen. Im Temperaturbereich um -200 °C kann ein mehrfaches des ursprünglichen Spannungswertes gemessen werden. Bei der Ermittlung der angegebenen Werte wurden die Dioden mit konstantem Strom von 10 mA gespiesen. Die Dioden a) und b) sind beide mit Stickstoff dotiert. Die Kennlinie a) zeigt eine grün emittierende Leuchtdiode und b) eine gelb emittierende. Die Kurve c) hingegen zeigt das Verhalten einer rot emittierenden Leuchtdiode ohne-Stickstoffdotierung.

Anhand von Figur 2 wird ein Ausführungsbeispiel einer Flüssiggasnachfüllvorrichtung beschrieben. Von der Stromquelle 1 gelangt über den Kontakt 4 zum Sensor 2 über den Kontakt 5 ein Strom zur LED 6, wobei die Sensoren 2 und 3 insbesondere grün beziehungsweise gelb leuchtende pn-Uebergänge (LED's) darstellen. Der Schwellwertdetektor 7 ist so eingestellt, dass bei einem Ausfall des Stromes der Stromquelle 1 ein Alarmsignal ausgelöst wird und die Kontakte 4 und 5 des Relais 15 eine andere Lage einnehmen. Der Sensor 3 ist dann eingeschaltet. Die Alarmlogik 14 wertet dies aus, bringt je nach eingeschaltetem Sensor die LED 16 oder LED 17 zum Aufleuchten und signalisiert den Schaltzustand der Alarmlogik 14. Stellt der Schwellwertschalter 20 fest, dass ein von ihm bestimmter oberer Spannungspegel überschritten wird, geht an die Alarmlogik 14 ebenfalls ein Signal und die Kontakte 4 und 5 schalten vom Sensor 2 auf den Sensor 3 um. Sind beide Sensoren 2 und 3 defekt, wird dies von der Alarmlogik 14 über die LED's 16 und 17 sowie den Schallwandler 19 akustisch gemeldet.

Sinkt im Arbeitsbehälter 10 der Flüssiggaspegel so weit ab, dass sich die Sensoren 2 oder 3 (je nachdem welcher Sensor durch die Kontakte 4 und 5 eingeschaltet ist) mit dem Flüssigkeitsspiegel nicht mehr berühren, gibt der Schwellenwertschalter 8 ein Signal an die Steuerlogik 13. Das Dreiwegeventil 11 schaltet von der Stellung "Abdampfen" auf "Druckluft füllen". Der Vorratsbehälter 9 wird gegenüber der Aussenwelt abgedichtet. Ueber die Ueberlaufleitung 11 gelangt das verflüssigte Gas zum Behälter 10 und berührt bei entsprechendem Pegelstand die Sensoren 2 und 3. Je nachdem, welcher Sensor (2 oder 3) durch die Alarmlogik 14 aktiviert ist, erfolgt die Rückmeldung an die Steuerlogik 13, dass der obere Pegel wieder erreicht ist.

Um Fehldeutungen durch Flüssiggasspritzer zu vermeiden, werden einzelne kurze Impulse durch den Tiefpass 24 unterdrückt. Bei einem dauernden Erreichen des Flüssiggaspegels der Sensoren 2 oder 3 wird durch die Logik 13 die Zeitbegrenzung 22 ausgelöst. Ihre Zeitkonstante bestimmt eine gewisse Nachfüllzeit. Sie wird so gewählt, dass im normalen Funktionsablauf soviel Flüssiggas nachgefüllt wird, dass die Sensoren 2 und 3 immer sicher eintauchen. Die Zeitkonstante der Zeitbegrenzung 22 ist aber immer kleiner als die der Zeibegrenzung 21. Ist die Zeitkonstante der Zeitbegrenzung 22 abgelaufen, wird das Ventil 11 über das Stellglied 12 von der Steuerlogik 13 wieder in die Ruhelage versetzt.

Mit dem Auslösen des Ventils 11 wird von der Steuerlogik 13 gleichzeitig das Zeitglied 21 ausgelöst. Es bestimmt die maximal mögliche Füllzeit. Wird innerhalb der vom Zeitglied 21 vorgegebenen Zeitspanne das Ansteigen des Flüssiggaspegels nicht erreicht, wird vom Zeitglied 21 in der Alarmlogik 14 eine unerlaubte Betriebsweise signalisiert. Damit wird überwacht, ob der Vorratsbehälter 9 leer ist, die Druckluft fehlt, die Leitung 11 vereist ist etc. Wird die maximal mögliche Füllzeit, die vom Zeitglied 21 bestimmt wird, überschritten, erhält die Alarmlogik 14 ebenfalls ein Signal und die LED 18 gibt Dauerlicht. Gleichzeitig wird der Schallwandler 19 aktiviert. Der Normalfüllvorgang wird durch Blinken des optischen Signals 18 angezeigt.

Anstelle des Mediums Druckluft kann auch ein Heizer 23 im Vorratsgefäss 9 untergebracht werden, der durch Verdampfen von Flüssiggas Druck erzeugt. Die Arbeitsweise des Ventils 11 ist dabei die gleiche.

Die einzelnen Betriebszustände der Vorrichtung werden nach aussen durch die optischen Signale 16 und 17 (LED's) sowie akustisch durch den Schallwandler 19 signalisiert.

## Patentansprüche

1. Anordnung zur Niveaumessung verflüssigter Gase mit Temperaturen kleiner minus 50° C mit mindestens einem Sensor (2, 3), dadurch gekennzeichnet, dass der Sensor (2, 3) ein pn-Halbleiterübergang auf der Basis von GaP ist wobei eine wesentliche Dotierkomponente der pn-Struktur Stickstoff ist, und dass eine Auswerteeinheit vorgesehen ist, die eine vom pn-Halbleiterübergang bestimmte Flussspannungsänderung mißt.

2. Anordnung zur Niveaumessung verflüssigter Gase mit Temperaturen kleiner minus 50° C mit mindestens einem Sensor (2, 3), dadurch gekennzeichnet, dass der Sensor (2, 3) ein pn-Halbleiterübergang auf der Basis von GaP ist wobei eine wesentliche Dotierkomponente der pn-Struktur Stickstoff ist, so dass diese bei elektrischer Speisung eine LED bilden, welche Licht emittiert, und dass eine Auswerteeinheit vorgesehen ist, die eine spektrale Änderung der Lichtemission mißt.

3. Anordnung nach einem der Ansprüche 1 oder 2, dadurch gekennzeichnet, dass mindestens 2 Sensorelemente (2, 3) in unterschiedlicher Höhe angeordnet sind, und dass die Niveaudetektion damit in diskreten Schritten erfolgt.

4. Anordnung nach einem der Ansprüche 2 oder 3, dadurch gekennzeichnet, dass die Auswerteeinheit mindestens einen auf die spektrale Emissionscharakteristik des Sensors (2, 3) abgestimmten Photoempfänger umfasst.

5. Anordnung nach Anspruch 4, dadurch gekennzeichnet, dass für die Abstimmung des Photoempfängers mindestens ein optisches Filterelement dem Photoempfänger oder Sender zugeordnet ist.

6. Anordnung nach Anspruch 5, dadurch gekennzeichnet, dass der Sensor (2, 3), der Photoempfänger und das Filterelement als kompakte Einheit aufgebaut sind.

7. Anordnung nach einem der Ansprüche 1 bis 6, dadurch gekennzeichnet, dass das Signal eine Nachfüllsteuerung für das Flüssiggas steuert, als gemessene Ist-Grösse in einem Füllstand-Regel Kreis.

8. Verfahren zur Niveaumessung verflüssigter Gase mit Temperaturen kleiner minus 50° C, gekennzeichnet durch Erfassung der Temperaturänderung bei Annäherung und Eintreten ins Flüssiggas mittels Auswertung der Flussspannungsänderung und/oder der spektralen Lichtemissionsänderung eines pn-Halbleiterüberganges (2, 3) auf GaP Basis mit Stickstoff als wesentlichem Dotierungsanteil.

## Claims

1. An arrangement for measuring the level of liquified gases of temperatures lower than minus 50°C comprising at least one sensor (2, 3) characterized in that the sensor (2, 3) has a pn semiconductor junction on a GaP base where nitrogen is an essential doping component of the pn structure and that a signal evaluation unit is foreseen to measure a forward voltage change determined by the pn structure.

2. An arrangement for measuring the level of liquified gases of temperatures lower than minus 50°C comprising at least one sensor (2, 3)characterized in that the sensor (2, 3) has a pn semiconductor junction on a GaP base where nitrogen is an essential doping component of the pn structure so that they form a LED which emits light when electrically supplied, and that a signal evaluation unit is foreseen to measure a spectral variation of the light emission.

3. Arrangement as claimed in one of the claims 1 or 2 characterized in that at least 2 sensor elements (2, 3) are positioned at different levels and that the level detection thus is operated in at least two steps.

4. Arrangement as claimed in one of the claims 2 or 3 characterized in that the signal evaluation unit comprises at least one photo receiver tuned to the spectral emission characteristic of the sensor (2, 3).

5. Arrangement as claimed in claim 4, characterized in that for the tuning of the photo receiver at least one optical filter element is allocated to the photo receiver or the transmitter.

6. Arrangement as claimed in claim 5 characterized in that the sensor (2, 3), the photo receiver and the filter element are built as a compact unit.

7. Arrangement as claimed in one of the claims 1 through 6 characterized in that the signal controls a refill control for the liquified gas, as a measured actual value in a filling level control loop.

8. Method for measuring the level of liquified gases of temperatures lower than minus 50°C characterized in that the temperature variation is measured when approaching and entering into the liquified gas by means of evaluation of the forward voltage and/or the spectral light emission change of a pn semiconductor junction (2, 3) on a GaP base where nitrogen is an essential doping component.

## Revendications

1. Agencement de mesure de niveau de gaz liquéfiés à des températures inférieures à moins 50° C incluant au moins un capteur (2, 3), caractérisé en ce que le capteur (2, 3) est une jonction semi-conductrice pn à base de GaP, où un composant de dopage essentiel de la structure pn est l'azote, et en ce qu'il est prévu une unité d'évaluation qui mesure une variation de tension de flux déterminée par la jonction semi-conductrice pn.

2. Agencement de mesure de niveau de gaz liquéfiés à des températures inférieures à moins 50° C incluant au moins un capteur (2, 3), caractérisé en ce que le capteur (2, 3) est une jonction semi-conductrice pn à base de GaP, où un composant de dopage essentiel de la structure pn est l'azote, de sorte que ces semi-conducteurs constituent, sous l 'effet d'une alimentation électrique, une diode électroluminescente qui émet une lumière et en ce qu'il est prévu une unité d'évaluation qui mesure une variation spectrale de l'émission lumineuse.

3. Agencement selon l'une des revendications 1 ou 2, caractérisé en ce qu'au moins 2 éléments capteurs (2, 3) sont disposés à des hauteurs différentes et en ce que la détection de niveau s'effectue ainsi par étapes discrètes.

4. Agencement selon l'une des revendications 2 ou 3, caractérisé en ce que l'unité d'évaluation comprend au moins un photorécepteur accordé avec la caractéristique d'émission spectrale du capteur (2, 3).

5. Agencement selon la revendication 4, caractérisé en ce qu'au moins un élément de filtrage optique est associé au photorécepteur ou à l'émetteur pour l'accord du photorécepteur.

6. Agencement selon la revendication 5, caractérisé en ce que le capteur (2, 3) le photorécepteur et l'élément de filtre sont assemblés en une unité compacte.

7. Agencement selon l'une des revendications 1 à 6, caractérisé en ce que le signal commande, pour le gaz liquéfié, une commande de remplissage sous la forme d'une valeur réelle mesurée dans un circuit régulateur de niveau.

8. Procédé de mesure du niveau de gaz liquéfiés à des températures inférieures à moins 50° C caractérisé par une détection de la variation de température lors d'une approche du gaz liquéfié et d'une entrée dans celui-ci au moyen d'une évaluation de la variation de tension de flux et/ou de la variation d'émission spectrale lumineuse d'une jonction semi-conductrice pn (2, 3) à base de GaP où l'azote est une fraction de dopage essentielle.
